# EUROPEAN PATENT APPLICATION

(11) **EP 4 339 738 A1**
(43) Date of publication of application: **20.03.2024**
(21) Application number: 22196112.1
(22) Date of filing: 16.09.2022
(51) Int. Cl.: G06F 1/26, G01R 31/00

(54) **MEASUREMENT APPLICATION DEVICE, MEASUREMENT APPLICATION SETUP AND METHOD**

(71) Applicant: Rohde & Schwarz GmbH & Co. KG, 81671 München (DE)
(72) Inventor: Fastner, Tobias, 85540 Haar-Gronsdorf (DE); Mikhailov, Yassen, 82319 Starnberg (DE); Mellouli, Mohamed, 85540 Haar (DE)
(74) Representative: Kehl, Ascherl, Liebhoff & Ettmayr Patentanwälte Partnerschaft mbB

(57) **Abstract**

The present disclosure provides a measurement application device, comprising a number of signal measurement paths, each one of the number of signal measurement paths comprising a plurality of signal processing components, and a scheduler coupled to the number of signal measurement paths, wherein the scheduler is configured to selectively control at least one of the signal measurement paths depending on a selected one of a number of operating modes to power down at least one of the signal processing components, or to power up at least one of the signal processing components. The present disclosure further provides a measurement application setup and a respective method.

## Description

### TECHNICAL FIELD

The disclosure relates to a measurement application device, a measurement application setup and a respective method.

### BACKGROUND

Although applicable to any type of measurement application device, the present disclosure will mainly be described in conjunction with oscilloscopes and vector network analyzers, VNAs.

While developing or maintaining electronic devices, users may be required to perform a plurality of different measurement application tasks, like measuring electrical signals in a device under test, DUT.

The measurement application devices employed in such measurement applications consume a large amount of electrical power.

Accordingly, there is a need for reducing the power consumption of measurement application devices.

### SUMMARY

The above stated problem is solved by the features of the independent claims. It is understood, that independent claims of a claim category may be formed in analogy to the dependent claims of another claim category.

Accordingly, it is provided:
A measurement application device, comprising a number of signal measurement paths, each one of the number of signal measurement paths comprising a plurality of signal processing components, and a scheduler coupled to the number of signal measurement paths, wherein the scheduler is configured to selectively control at least one of the signal measurement paths depending on a selected one of a number of operating modes to power down at least one of the signal processing components, or to power up at least one of the signal processing components.

Further, it is provided:
A measurement application setup, comprising a central controller, and a plurality of measurement application devices according to the present disclosure that are communicatively coupled to the central controller, wherein the central controller is configured to retrieve usage statistics from the measurement application devices, and wherein the central controller is configured to receive a user input and to transmit the user input to at least one of the measurement application devices, the user input indicating at least one of an operation mode and an operations time schedule.

Further, it is provided:
A method for controlling a measurement application device according to the present disclosure, the method comprising selectively controlling at least one of the signal measurement paths depending on a selected one of a number of operating modes to power down at least one of the signal processing components, or to power up at least one of the signal processing components of the respective signal measurement path.

The present disclosure is based on the finding that known measurement application devices either consume a lot of electrical energy or may be completely powered down.

However, depending on the type of measurement application device, such a measurement application device may require a long time to reach an operating temperature. Defined operating temperatures may, for example, be required in order to achieve a low temperature drift of electrical components in the respective measurement application device.

For example, modern vector network analyzers, VNAs, may require up to 90 minutes to reach the required operating temperature.

The present disclosure, in contrast to such measurement application devices, provides a measurement application device that may selectively power down or power up single elements or signal processing components of the signal measurement paths depending on a selected operation mode. The expression "a number" of signal measurement paths refers to the measurement application device comprising one or more signal measurement paths. The expression "a number of operating modes" refers to one or more operating modes being defined.

Depending on the specific implementation of the measurement application device, the single signal measurement paths may comprise different signal processing components. In embodiments, the measurement application device may comprise a signal measurement device, while in other embodiments, the measurement application device may comprise a signal generation device. It is understood, that such different types of measurement application devices may comprise different signal processing components in the signal measurement paths. Possible measurement application devices may comprise, but are not limited to, signal analyzers, like vector network analyzers, signal generators, like vector signal generators, oscilloscopes, EMI test receivers, and spectrum analyzers.

The expression "signal processing components" in this regard may refer to any type of electric or electronic component that requires electrical power to operate correctly, and may, consequently, be supplied with electrical power to operate, or may be powered down by turning off the electrical energy supply.

Possible signal processing components may comprise, but are not limited to, at least one of a reflectometer, a generator, a receiver, a coupler, a calibration line, or any sub-component of these.

As will be described in more detail below, a plurality of different operation modes may be defined for the measurement application device, and the scheduler may control different ones of the signal processing components of the different signal measurement paths to be powered down or to be powered on.

Further, it is to be understood, that the expression "power down" not necessarily requires to completely power off the respective signal processing component. Instead, the expression "power down" may also refer to operating the respective signal processing component in an operating mode that reduces the power consumption of the respective signal processing component, i.e., in a power-saving operating mode.

The scheduler, consequently, allows flexibly adapting which of the signal processing components are supplied with electrical power and which of the signal processing components are powered down, depending on the current measurement application task that is being performed with the measurement application device.

It is understood, that a single operating mode may be defined for a measurement application device. Such an operating mode may be seen as a single energy saving operating mode in addition to a standard mode of the measurement application device. If the single selected operating mode is applied, the scheduler will power down at least some components of the measurement application device, while in the standard mode none of the elements of the measurement application device will be powered down.

Operating modes that comprise powering down at least one of the signal processing components in at least one of the signal measurement paths may, consequently, be referred to as energy saving operating modes.

In embodiments, other components than the explicitly stated signal processing components of the signal measurement paths may also be powered down by the scheduler. Such other components may, for example, comprise, but are not limited to, display devices, processing elements, communication interfaces, and user input devices.

The scheduler may be provided as a dedicated processing element, like e.g., a processing unit, a microcontroller, a field programmable gate array, FPGA, a complex programmable logic device, CPLD, or the like. The scheduler may at least in part also be provided as a computer program product comprising computer readable instructions that may be executed by a processing element. In a further embodiment, the scheduler may be provided as addition or additional function or method to the firmware or operating system of a processing element that is already present in the respective application as respective computer readable instructions. Such computer readable instructions may be stored in a memory that is coupled to or integrated into the processing element. The processing element may load the computer readable instructions from the memory and execute them.

In addition, it is understood, that any required supporting or additional hardware may be provided like e.g., a power supply circuitry and a clock generation circuitry.

The measurement application setup may be seen as a kind of networked measurement system, where a central controller may be used to control a plurality of measurement application devices.

In such a measurement application setup, the single measurement application devices may be communicatively coupled to the central controller via any kind of data network or communication system.

The central controller may retrieve usage statistics from the single measurement application devices. The usage statistics may comprise the currently activated operating mode, and any operations time schedule that may be active in the respective measurement application device. The usage statistics may also comprise information about the daily usage of the respective measurement application device by its users independently of any operating modes or operations time schedules. Further types of usage statistics may also comprise information about the port or ports of the measurement application device that may be used by the user. This information may be provided as a probability that may, for example, be calculated based on prior usage of the single ports of the measurement application device by the user. It is understood, that a port will usually be linked to a signal measurement path and will provide a coupling means to couple the respective signal measurement path e.g., with cables and devices under test.

The central controller may receive user input to control the plurality of measurement application devices. To this end, the central controller may provide a user interface. Such a user interface may comprise a website hosted by the central controller, or an application that a user may install on a device and use to interact with the central controller.

A user may provide a user input to the central controller that indicates an operation mode or an operations time schedule for a respective one or a group of the measurement application devices. The central controller may then forward the respective user input to the respective measurement application device(s), where the scheduler may then operate the measurement application device(s) accordingly.

With the central controller a unified management of a plurality of measurement application devices is possible.

Further embodiments of the present disclosure are subject of the further dependent claims and of the following description, referring to the drawings.

In an embodiment, the scheduler may be configured to control the number of signal measurement paths based on at least one of an operations time schedule and a user input.

The operations time schedule may comprise a list-like or calendar-like collection of information regarding operating times of the measurement application device. The expression "operating time" in this regard refers to a time and/or a duration for which the measurement application device is expected to be fully operational.

Such an "operating time" may for example be defined by indicating a day of the week or a day of the month or a day of the year together with a start time and an end time. Of course, multiple operating times may be defined for a single day.

In embodiments, each operating time may be interpreted as a time at which the measurement application device is required to be fully operational and no one of the elements of the measurement application device may be powered down.

The operations time schedule may, for example, be stored in a memory of the measurement application device, for example a memory that is coupled to the scheduler and allows the scheduler to read data from that memory.

In further embodiments, the operations time schedule may in addition or as alternative be provided externally to the measurement application device. In such an embodiment, the measurement application device may comprise a communication interface, for example an Ethernet interface, that couples the measurement application device to a network. The operations time schedule may in such an embodiment be stored, for example, on a respective server e.g., the central controller.

It is understood, that the communication interface may comprise any kind of wired and wireless communication interface, like for example a network communication interface, especially an Ethernet, wireless LAN or WIFI interface, a USB interface, a Bluetooth interface, an NFC interface, a visible or non-visible light based interface, especially an infrared interface.

It is further understood, that the measurement application device and the respective server may communicate via an intermediary network with each other, and that such a network may comprise any type of network devices, like switches, hubs, routers, firewalls, and different types of network technologies.

The scheduler may also receive a respective user input in order to control the signal measurement paths. Such a user input may specifically indicate, which elements of the signal measurement paths are to be powered down by the scheduler. The user input may define user preferences that indicate which ones of the signal measurement paths will be used by the user. The user preferences may also refer to a measurement task that is to be performed. If the user indicates that a specific measurement task is to be performed at a specific time, the scheduler may activate or powerup the respective signal processing components accordingly.

To this end, the measurement application device may comprise a respective user input interface. The user interface may comprise any type of input device that may be actuated by a user. Such a user interface may comprise a user interface of the measurement application device or an external user interface. Exemplary input devices may for example comprise at least one of keys, buttons, a mouse, a keyboard, a touch panel, and a touch pad. The user interface may also comprise a website that is hosted by the measurement application device or a server that is communicatively coupled to the measurement application device.

In embodiments, the user may also define an operations time schedule via a respective user input. The user may for example be provided with a diagram view of a day and may insert one or multiple operating times for that day, and may indicated which of the signal measurement paths or signal processing components will be needed. Of course, the user may also change the currently displayed day to provide operating times for any day of the year. If the operations time schedule is provided by a server to the measurement application device, the server may provide a respective user interface.

It is understood, that multiple operations time schedules may be defined for a measurement application device. The user may, for example, select which operations time schedule is to be used by the measurement application device. In other embodiments, the server or any other entity may control the measurement application device to use a specific one of the available operations time schedules.

In a further embodiment, each one of the operating modes may define which signal processing components of which ones of the signal measurement paths are to be powered down.

Each one of the operating modes may define for different ones of the signal processing components that they are to be powered down. With such operating modes, it is possible to flexibly adjust which signal processing components are powered up and which signal processing components are powered down at what times.

The power consumption of the measurement application device may, consequently, be optimized by adjusting the single operating modes to specific measurement tasks.

To this end, an operating mode may specify that only those signal processing components should be powered up that are required to perform a specific measurement task.

In yet another embodiment, at least one of the operating modes may specify that at least one of:
at least one of the signal measurement paths is to be completely powered down, while at least one of the signal processing components of at least one of the signal measurement paths is to be powered up;
at least one of the signal measurement paths is to be completely powered down, while at least one of the signal measurement paths is to be completely powered up i.e., all signal processing components of the respective signal measurement path are powered up; and
all of the signal measurement paths are to be completely powered down.

It is understood, that a user may via the user input directly control the scheduler to power up or power down any of the signal processing components as will be described below for the operating modes. A respective user interface may be provided to the user. By using the defined operation modes, the user is not required to manually select the signal processing components that are to be activated every time.

With an operating mode that defines that at least one of the signal measurement paths is to be completely powered down, while at least one of the signal processing components of at least one of the signal measurement paths is to be powered up, unused signal measurement paths may be completely powered down. Other signal measurement paths, that are required in the respective measurement application may in contrast be powered up, or at least in part be powered up.

This allows, for example, defining an operating mode that activates signal processing components in specific signal measurement paths that are required for a measurement task. At the same time, the signal measurement paths that are not required for the measurement task may be powered down completely.

If multiple operating modes are defined, for example, by a user, the single operating modes may differ in at least one of the signal processing components that is to be powered up or powered down or in at least one of the signal measurement paths that are to be completely powered up or powered down.

Other operating modes may define that at least one of the signal measurement paths is to be completely powered down, while at least one of the signal measurement paths is to be completely powered up. Such an operating mode allows activating only those signal measurement paths that are actually needed for a measurement task, while all other signal measurement paths may be powered down completely.

A user may for example use only two input ports of a measurement device that has four or more input ports for a specific measurement task. A respective operation mode may, consequently, power down the unused input ports and only power up the two required input ports.

Different operating modes may be provided for different users. For example, a user A may require two specific input ports of a measurement device, and user B may require other two or three or more input ports of the measurement device to be operational for a specific measurement task. Of course, every user may store such operating modes for use by the scheduler.

It is understood, that the measurement application device may comprise any number of ports and that at least one signal measurement path is provided for each one of the ports.

Another operating mode may define that all of the signal measurement paths are to be completely powered down. Such an operating mode may also be called a "standby operating mode", while other operating modes that power up at least some of the signal processing components may be called "green mode".

In embodiments, multiple different operating modes may be defined that form a sequence of operating modes for an operations time schedule. For example, at least one operating mode may be defined for warming up the respective signal processing components that are needed for a measurement task. A further operating mode may be defined that activates all signal processing components required for performing the respective measurement task.

The operations time schedules may, consequently, also define a sequence of operating modes to be used and specific times for activating the operating modes in the respective operations time schedule.

An operating mode that is used to warm up specific signal processing components, may instruct the scheduler to only activate the respective signal processing components that need warming up, while other signal processing components of the same signal measurement path may be kept in a powered-down mode until the measurement task is started. This allows reducing the power consumption of the measurement application device even though the measurement application device is already warming up.

If a single measurement application device is used by multiple users, and the users defined different operating modes that use different signal measurement paths, the scheduler may also be configured to identify, if specific ones of the signal processing components of currently unused signal measurement paths are required in the near future and in addition to the currently active operating mode activate a warm-up operation mode that indicates to warm-up the signal processing components of the signal measurement paths that will be needed in the near future.

In another embodiment, the scheduler may be configured to select an operating mode based on at least one of the operations time schedule and the user input.

Above it is indicated that during a defined operation time, the measurement application device may be required to be fully operational, and therefore, fully powered. However, there are other times, where only some of the signal processing components are required to be powered up.

The operations time schedules define, which operation modes should be used at which time i.e., which signal processing components should be powered up or not at the respective point in time.

The scheduler may, therefore, select an operating mode based on at least one of the operations time schedule to provide the required signal processing components with electrical power.

In an embodiment, the measurement application device may comprise an artificial intelligence-based scheduling module that is pre-trained based on usage statistics of the measurement application device to define operating modes and operations time schedules based on the usage of the measurement application device.

The artificial intelligence-based scheduling module may be provided as component of the scheduler or as a dedicated component. The explanations provided above regarding the specific embodiment of the scheduler apply mutatis mutandis to the artificial intelligence-based scheduling module. As alternative, the artificial intelligence-based scheduling module may also be provided in a respective server that may be communicatively coupled to the measurement application device via a respective communication interface as mentioned above.

The artificial intelligence-based scheduling module may in embodiments comprise a neural network or may apply any other AI algorithm that is adequate for defining the operating modes and operations time schedules.

The artificial intelligence-based scheduling module may be factory-trained. That means that the artificial intelligence-based scheduling module may be trained by the manufacturer of the measurement application device with training data that may be provided by the manufacturer. Of course, the manufacturer may gather usage statistics from a plurality of measurement application device that he possess or sold to customers as training data.

The pre-trained artificial intelligence-based scheduling module may then analyze the usage of the measurement application device by its users and define respective operating modes and operations time schedules. The artificial intelligence-based scheduling module may also control the scheduler to use the newly defined operating modes and operations time schedules.

The artificial intelligence-based scheduling module may in embodiments analyze, which ports i.e., signal measurement paths, of the measurement application device are used at which times of the day and at which days of the week, month or year. To this end, the artificial intelligence-based scheduling module may analyze the current configuration of the measurement application device and determine if a port is used. In addition, or as alternative, the artificial intelligence-based scheduling module may perform measurements, for example, impedance measurement, via the ports of the measurement application device to identify if the respective ports are coupled to another device or not i.e., if they are used or not.

If the artificial intelligence-based scheduling module is based on a neural network, the neural network may comprise inputs or input nodes for different types of information. The information provided to the neural network may comprise, but is not limited to, at least one of a time, a date, a weekday, and information about the power status of the single signal processing components at the indicated time. The neural network may output information about which signal processing components may be powered down or powered up at which time and date.

Of course, the neural network may also be provided with additional information. The neural network may for example be provided with calendar entries of a user or group of users that indicate, when the user or single users of the group are working or absent. The neural network may also be provided with information about national holidays or any other reason that may cause the work with the measurement application device to be suspended at a specific day.

In a further embodiment, the measurement application device may comprise a communication interface that is coupled to the scheduler and that is configured to receive an activation command, wherein the scheduler may be configured to control the signal measurement paths to power up all signal processing components based on the activation command, or to select an operation mode indicated by the activation command.

The activation command may be used by a user to remotely activate the measurement application device, even if the currently selected or activated operations time schedule indicates that the measurement application device is to be powered down.

The activation command may either fully activate the measurement application device or may indicate an operation mode to be activated in the measurement application device.

A user may, for example, use the activation command if he suddenly is required to perform a measurement task and is on his way to his laboratory. In an exemplary application, a user may issue the activation command, for example, from his home on a holiday, and then drive to the laboratory. Instead of activating the measurement application device after his arrival, the measurement application device will then already be warmed-up and ready to perform a measurement.

In yet another embodiment, the measurement application device may comprise at least one heating element that may be configured to controllably heat-up at least one of the signal processing components, wherein the scheduler may be configured to control the heating element based on the selected one of the operating modes.

Usually, the signal processing components are not manufactured to generate as much heat as possible. In contrast, the manufactures of the single signal processing components usually try to reduce the power loss i.e., the heat generation, in the signal processing components as much as possible.

As indicated above, a certain operating temperature may be needed for the signal processing components to reach thermal equilibrium and operate with the specified measurement accuracy. If only the signal processing components are used to heat up themselves, while they are usually designed to waste as little electrical energy as possible and, therefore, heat up as little as possible, the warm-up procedure may require a considerable amount of time and electrical power.

With the dedicated heating element, the signal processing components may, in contrast, be heated up quickly. Further, heating elements are optimized to produce heat in contrast to the signal processing components. Consequently, with the help of the heating element, the signal processing components may be brought up to operating temperature quicker and more efficiently.

It is understood, that the operations time schedules and the operating modes may take into account the presence of the heating element.

In another embodiment, the measurement application device may comprise a status interface that may be configured to output the current operating state of the measurement application device.

The status interface may comprise at least one of, but is not limited to, a light on the housing of the measurement application device and switching the light on/off or changing the color of the light or blinking the light, and an icon that is displayed on a display of the measurement application device or on a website for the measurement application device.

The status interface serves for informing a user of the current operating state of the measurement application device. To this end, the status interface may indicate the operating state that is currently selected for the measurement application device.

The status interface may also indicate the current state of the measurement application device. The state may, for example, refer to the measurement application device warming up or having reached the ready state.

While the measurement application device is still warming up, a light, especially a backlight of a knob or other input element, may be pulsed, for example, in red color.

The status interface may in addition or as alternative indicate separately which port or signal measurement path is read to be operated, powered down or heating up. Such a status interface may be implemented e.g., at a front plate of the measurement application device, for example, in form of one or more LEDs. Such an indication may be provided, for example, next to the single ports.

In an embodiment, the measurement application device may comprise a central processing unit that may be coupled to the signal measurement paths, and a display that is coupled to the central processing unit, wherein the scheduler may further be configured to control the central processing unit and the display to power down or power up according to the selected operation mode.

The central processing unit may be a standard processor, an embedded or industrial computer or the like, that may be provided in the measurement application device to control elements of the measurement application device. Such central processing units are usually provided in addition to the highly specialized signal processing circuitry in a measurement application device to control for example user input and output devices, the display, and communication functions of the measurement application device.

While heating up specific signal processing components of the signal measurement paths, the central processing unit may not be required to be active. The same applies to the display of the measurement application device.

Therefore, the scheduler may also control the central processing unit and the display to power up or power down as needed. If the central processing unit is provided as an embedded or industrial computer, this computer may for example be put into any one of different hibernation modes of the computer or may be completely powered down.

The display may after being powered down, never be automatically powered up again. Instead, the display may in embodiments only be powered up after receiving any user input at the measurement application device.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a measurement application device according to the present disclosure;
Figure 2 shows a block diagram of an embodiment of another measurement application device according to the present disclosure;
Figure 3 shows a block diagram of a further embodiment of another measurement application device according to the present disclosure;
Figure 4 shows a block diagram of a further embodiment of another measurement application device according to the present disclosure;
Figure 5 shows a block diagram of an embodiment of a measurement application setup according to the present disclosure;
Figure 6 shows a block diagram of an embodiment of another measurement application device according to the present disclosure;
Figure 7 shows a block diagram of an embodiment of another measurement application device according to the present disclosure;
Figure 8 shows a flow diagram of an embodiment of a method according to the present disclosure;
Figure 9 shows an embodiment of a possible user information diagram to be used with a measurement application device according to the present disclosure; and
Figure 10 shows an embodiment of another possible user information diagram to be used with a measurement application device according to the present disclosure.

In the figures like reference signs denote like elements unless stated otherwise.

### DETAILED DESCRIPTION OF THE DRAWINGS

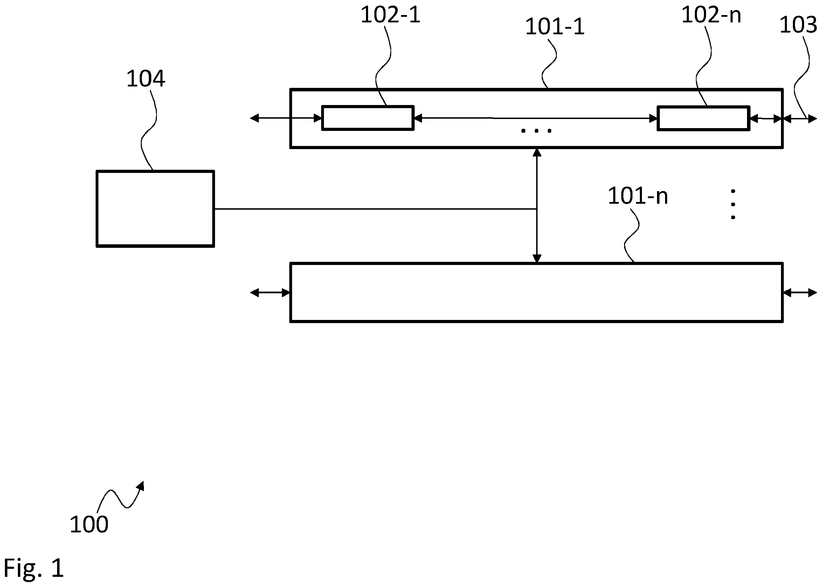

Figure 1 shows a block diagram of a measurement application device 100. The measurement application device 100 comprises a number of signal measurement paths 101-1 - 101-n that are coupled to a scheduler 104. Each one of the number of signal measurement paths 101-1 - 101-n comprises a plurality of signal processing components 102-1 - 102-n (only shown for signal measurement path 101-1). It is understood, that the number of signal measurement paths 101-1 - 101-n may vary for different measurement application devices 100. While two signal measurement paths 101-1 - 101-n are shown in the measurement application device 100, more signal measurement paths 101-1 - 101-n are hinted at by three dots. The same, applies to the signal processing components 102-1 - 102-n. While two signal processing components 102-1 - 102-n are shown in the signal measurement path 101-1, any other number of signal processing components 102-1 - 102-n is possible as hinted at by three dots.

The scheduler 104 may selectively control at least one of the signal measurement paths 101-1 - 101-n depending on a selected one of a number of operating modes to power down at least one of the signal processing components 102-1 - 102-n, or to power up at least one of the signal processing components 102-1 - 102-n.

In embodiments, the measurement application device 100 may be provided as a signal receiving or measurement device or as a signal emitting or generation device. Possible embodiments comprise signal analyzers, like vector network analyzers, oscilloscopes, EMI test receivers, and spectrum analyzers, and signal generators, like vector signal generators.

As explained above, the different operating modes may be defined for the measurement application device 100, depending on the measurement task to be performed. Further, the scheduler may rely on a plurality of operations time schedules that indicate which operation mode should be used at which specific point in time.

With these features of the scheduler 104, the energy consumption of the measurement application device 100 may easily be optimized.

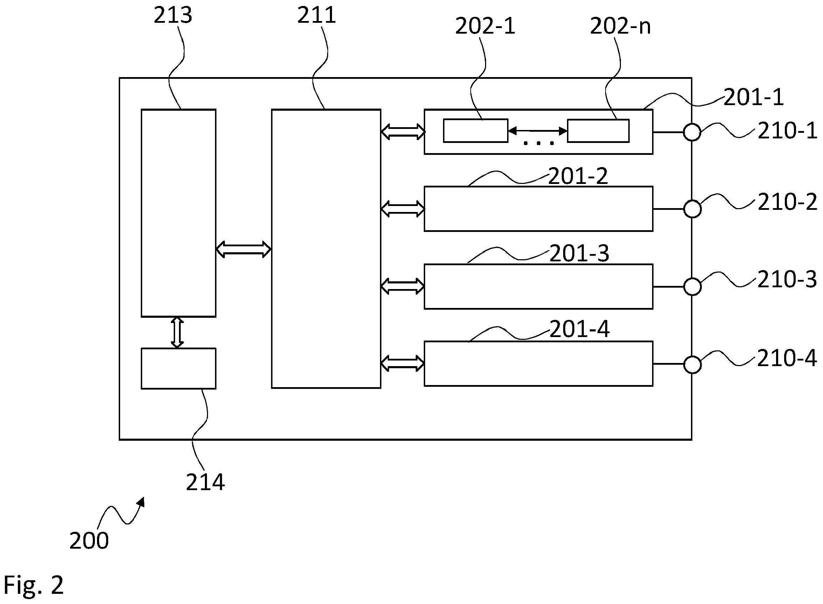

Figure 2 shows a block diagram of an embodiment of another measurement application device 200. The measurement application device 200 is based on the measurement application device 100. Consequently, the measurement application device 200 comprises four signal measurement paths 201-1 - 201-4, that each comprise a plurality of signal processing components 202-1 - 202-n. Although only two signal processing components 202-1 - 202-n are shown in the first signal measurement path 201-1, each one of the signal measurement paths 201-1 - 201-4 may comprise a respective number of signal processing components 202-1 - 202-n.

The measurement application device 200 further comprises four ports 210-1 - 210-4, wherein each one of the ports 210-1 - 210-4 is coupled to one of the signal measurement paths 201-1 - 201-4.

The four signal measurement paths 201-1 - 201-4 are coupled to a common signal processor 211. It is understood, that in other embodiments, dedicated signal processors may be provided for each one of the signal measurement paths 201-1 - 201-4. The signal processor 211 is coupled to a central processing unit 213, which is coupled to a display 214.

In the measurement application device 200, the signal processor 211 is provided to perform signal processing functions on signals acquired or provided by the measurement application device 200. The signal processor 211 may in embodiments be provided in an FPGA, ASIC or the like.

The central processing unit 213, in contrast, is provided to perform general management functions in the measurement application device 200, like controlling the display 214, and performing communications with other devices via a communication interface (not shown). The central processing unit 213 may in embodiments be provided as an embedded computer.

In the measurement application device 200, the scheduler is not explicitly shown, since the scheduler is implemented as a function of the central processing unit 213. Alternatively, the scheduler may also be implemented as a function of the signal processor 211. As further alternative, the scheduler may be implemented as dedicated element in the measurement application device 200 and may control the signal processor 211 and the central processing unit 213 in addition to controlling the signal measurement paths 201-1 - 201-4.

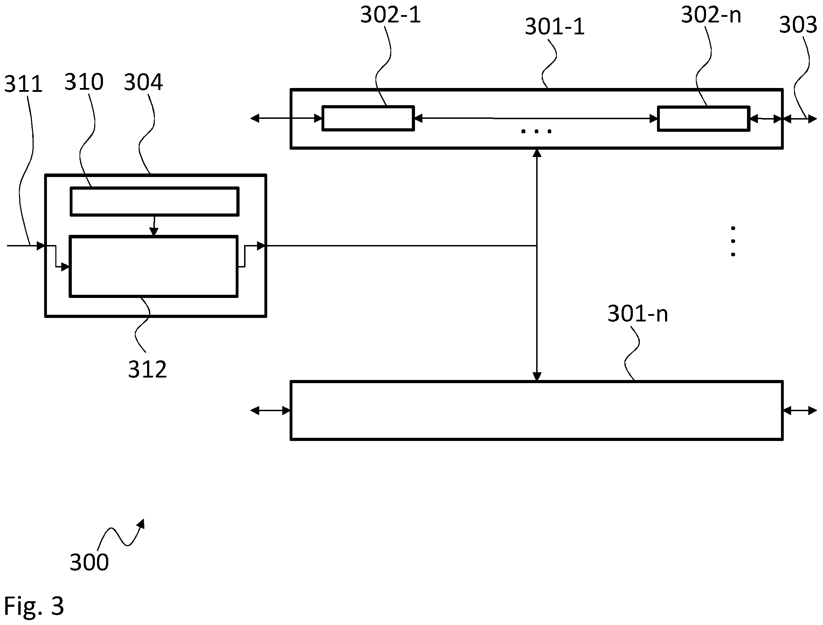

Figure 3 shows a block diagram of another measurement application device 300. The measurement application device 300 is based on measurement application device 100. Therefore, the measurement application device 300 comprises a number of signal measurement paths 301-1 - 301-n that are coupled to a scheduler 304. Each one of the number of signal measurement paths 301-1 - 301-n comprises a plurality of signal processing components 302-1 - 302-n. It is understood, that the number of signal measurement paths 301-1 - 301-n may vary for different measurement application devices 300. While two signal measurement paths 301-1 - 301-n are shown in the measurement application device 300, more signal measurement paths 301-1 - 301-n are hinted at by three dots. The same, applies to the signal processing components 302-1 - 302-n. While two signal processing components 302-1 - 302-n are shown in the signal measurement path 301-1, any other number of signal processing components 302-1 - 302-n is possible as hinted at by three dots.

The scheduler 304 comprises an operations time schedule 310 that is coupled to an artificial intelligence-based scheduling module 312. The artificial intelligence-based scheduling module 312 is further configured to receive a user input 311.

The artificial intelligence-based scheduling module 312 may determine based on information in the operations time schedule 310 and the user input 311, how to operate the measurement application device 300, and which signal measurement paths 301-1 - 301-n and signal processing components 302-1 - 302-n to power up or power down.

The artificial intelligence-based scheduling module 312 may also gather usage data about the usage of the measurement application device 300 and modify the operations time schedule 310 accordingly.

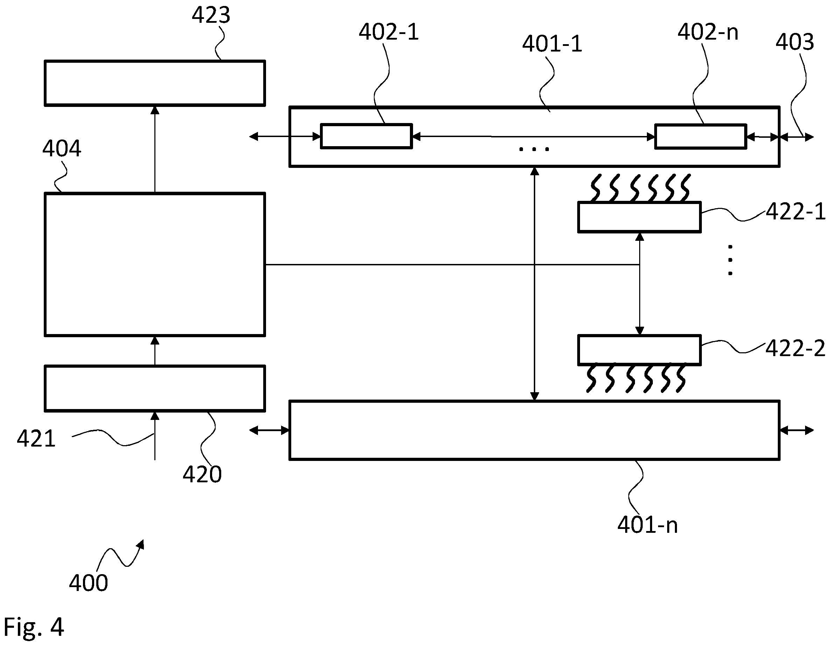

Figure 4 shows a block diagram of another measurement application device 400. The measurement application device 400 is based on the measurement application device 100. Therefore, the measurement application device 400 comprises a number of signal measurement paths 401-1 - 401-n that are coupled to a scheduler 404. Each one of the number of signal measurement paths 401-1 - 401-n comprises a plurality of signal processing components 402-1 - 402-n. It is understood, that the number of signal measurement paths 401-1 - 401-n may vary for different measurement application devices 400. While two signal measurement paths 401-1 - 401-n are shown in the measurement application device 400, more signal measurement paths 401-1 - 401-n are hinted at by three dots. The same, applies to the signal processing components 402-1 - 402-n. While two signal processing components 402-1 - 402-n are shown in the signal measurement path 401-1, any other number of signal processing components 402-1 - 102-n is possible as hinted at by three dots.

The measurement application device 400 further comprises a communication interface 420 that is coupled to the scheduler 404 for receiving an activation command 412. Further, a heating element 422-1, 422-2 that is coupled to the scheduler 404 is provided for each one of the signal measurement paths 401-1 - 401-n, and a status interface 423 is provided that is also coupled to the scheduler 404. It is understood, that each one of these additional elements that are coupled to the scheduler 404 is optional.

The communication interface 420 serves for the scheduler 404 to receive an activation command 412. The activation command 412 may be issued by a user to remotely activate the measurement application device 400 independently of any operations time schedule or set operation mode.

The heating elements 422-1, 422-2 may be activated by the scheduler 404 to speed-up the warm-up of the signal processing components 402-1 - 402-n of the respective signal measurement paths 401-1 - 401-n.

The scheduler 404 may use the status interface 423 to indicated to a user, in which state the measurement application device 400 currently operates or resides. The status interface 423 may, for example, comprise a light indicator that may be pulsed in red or orange while the measurement application device 400 is warming-up. As soon as the measurement application device 400 is operable, the status interface 423 may light up in green.

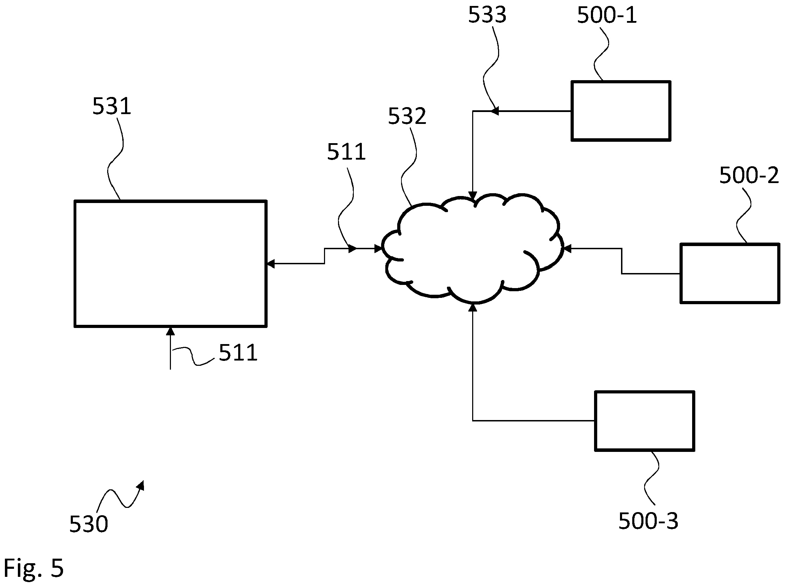

Figure 5 shows a block diagram of a measurement application setup 530. The measurement application setup 530 comprises a central controller 531 that is coupled via a network 532 with three measurement application devices 500-1, 500-2, 500-3. The network 532 may, for example, comprise a local network in a laboratory, or an office building, or a public network like the internet, or a combination of these networks.

The central controller 531 may comprise a server or (cloud) service that retrieves usage statistics 533 from the measurement application devices 500-1, 500-2, 500-3. In addition, or as alternative, the central controller 531 may serve for a user to provide user input 511 to the measurement application devices 500-1, 500-2, 500-3 via the network 532.

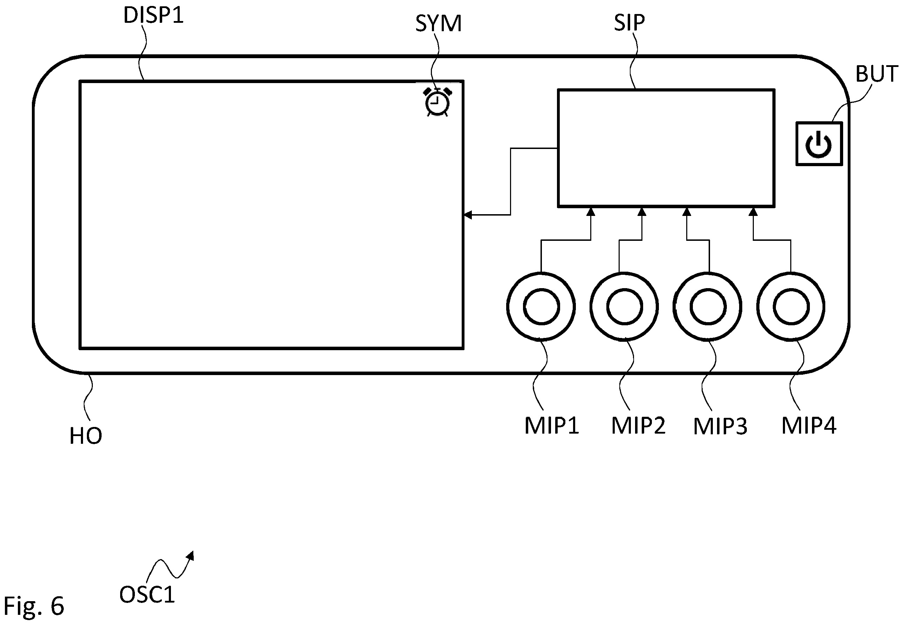

Figure 6 shows a block diagram of an oscilloscope OSC1 that may be used as an embodiment of a measurement application device according to the present disclosure.

The oscilloscope OSC1 comprises a housing HO that accommodates four measurement inputs MIP1, MIP2, MIP3, MIP4 that are coupled to a signal processor SIP for processing any measured signals. The signal processor SIP is coupled to a display DISP1 for displaying the measured signals to a user, and to a button BUT. The button BUT may be the power button of the oscilloscope OSC1.

Although not explicitly shown, it is understood, that the oscilloscope OSC1 may also comprise signal outputs that may also be coupled to the differential measurement probe. Such signal outputs may for example serve to output calibration signals. Such calibration signals allow calibrating the measurement setup prior to performing any measurement. The process of calibrating and correcting any measurement signals based on the calibration may also be called de-embedding and may comprise applying respective algorithms on the measured signals.

In embodiments, the scheduler according to the present disclosure may be provided in the signal processor SIP as an additional function of the signal processor SIP.

The scheduler may use the display DISP1 to show a symbol SYM to the user, that indicates the current operating state to the user. A clock-like symbol may for example indicate that the oscilloscope OSC1 is in an energy saving mode and that a time is scheduled for waking the oscilloscope OSC1.

The scheduler may use the button BUT to receive user input, for example, to immediately wake-up the oscilloscope OSC1 on a push of the button. In addition, the scheduler may use the button BUT to indicate, for example via a backlight of the button BUT, the current state of the oscilloscope OSC1. While warming-up the backlight may for example pulse with red or orange light. After warming-up, the backlight may be illuminated in green.

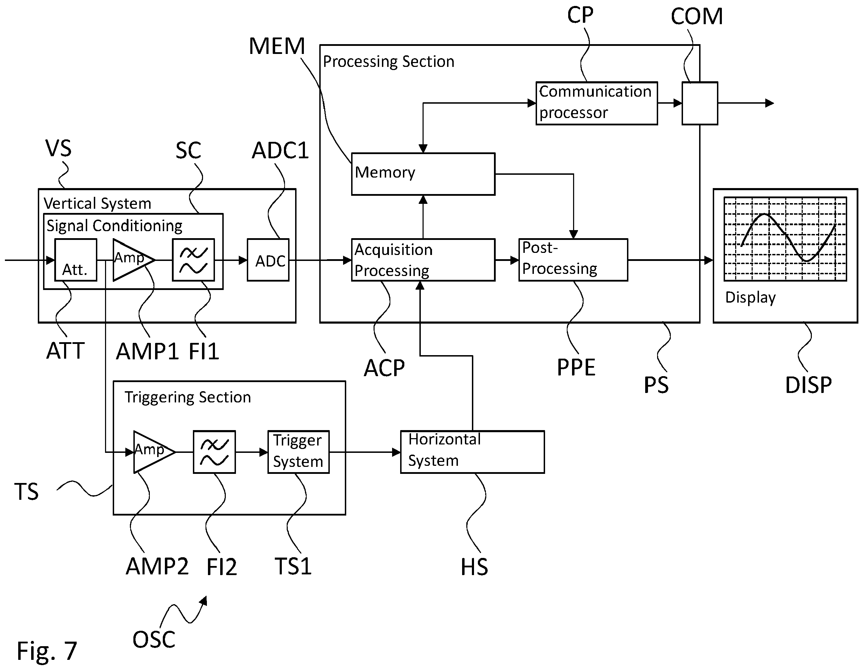

Figure 7 shows a block diagram of another oscilloscope OSC that may be used with a measurement application device according to the present disclosure. The oscilloscope OSC is implemented as a digital oscilloscope. However, the present disclosure may also be implemented with any other type of oscilloscope.

The oscilloscope OSC exemplarily comprises five general sections, the vertical system VS, the triggering section TS, the horizontal system HS, the processing section PS and the display DISP. It is understood, that the partitioning into five general sections is a logical partitioning and does not limit the placement and implementation of any of the elements of the oscilloscope OSC in any way.

The vertical system VS mainly serves for attenuating or amplifying a signal to be acquired. The signal may for example be modified to fit the signal in the available space on the display DISP or to comprise a vertical size as configured by a user.

To this end, the vertical system VS comprises a signal conditioning section SC with an attenuator ATT that is coupled to an amplifier AMP1. The amplifier AMP1 is coupled to a filter FI1, which in the shown example is provided as a low pass filter. The vertical system VS also comprises an analog-to-digital converter ADC1 that receives the output from the filter FI1 and converts the received analog signal into a digital signal.

The attenuator ATT and the amplifier AMP1 serve to scale the waveform of the signal and to condition the amplitude of the signal to be acquired to match the operation range of the analog-to-digital converter ADC1. The filter FI1 serves to filter out unwanted high frequency components of the signal to be acquired.

The triggering section TS comprises an amplifier AMP2 that is coupled to a filter FI2, which in this embodiment is implemented as a low pass filter. The filter FI2 is coupled to a trigger system TS1.

The triggering section TS serves to capture predefined signal events and allows the horizontal system HS to e.g., display a stable view of a repeating waveform, or to simply display waveform sections that comprise the respective signal event. It is understood, that the predefined signal event may be configured by a user via a user input of the oscilloscope OSC.

Possible predefined signal events may for example include, but are not limited to, when the signal crosses a predefined trigger threshold in a predefined direction i.e., with a rising or falling slope. Such a trigger condition is also called an edge trigger. Another trigger condition is called "glitch triggering" and triggers, when a pulse occurs in the signal to be acquired that has a width that is greater than or less than a predefined amount of time.

The triggering section TS operates on the signal as provided by the attenuator ATT, which is fed into the amplifier AMP2. The amplifier AMP2 serves to condition the input signal to the operating range of the trigger system TS1. It is understood, that a common amplifier may also be used instead of the dedicated amplifiers AMP1 and AMP2.

In order to allow an exact matching of the trigger event and the waveform that is shown on the display DISP, a common time base may be provided for the analog-to-digital converter ADC1 and the trigger system TS1.

It is understood, that although not explicitly shown, the trigger system TS1 may comprise at least one of configurable voltage comparators for setting the trigger threshold voltage, fixed voltage sources for setting the required slope, respective logic gates like e.g., a XOR gate, and FlipFlops to generate the triggering signal.

The triggering section TS is exemplarily provided as an analog trigger section. It is understood, that the oscilloscope OSC may also be provided with a digital triggering section. Such a digital triggering section will not operate on the analog signal as provided by the attenuator ATT but will operate on the digital signal as provided by the analog-to-digital converter ADC1.

A digital triggering section may comprise a processing element, like a processor, a DSP, a CPLD or an FPGA to implement digital algorithms that detect a valid trigger event.

The horizontal system HS is coupled to the output of the trigger system TS1 and mainly serves to position and scale the signal to be acquired horizontally on the display DISP.

The oscilloscope OSC further comprises a processing section PS that implements digital signal processing and data storage for the oscilloscope OSC. The processing section PS comprises an acquisition processing element ACP that is couple to the output of the analog-to-digital converter ADC1 and the output of the horizontal system HS as well as to a memory MEM and a post processing element PPE.

The acquisition processing element ACP manages the acquisition of digital data from the analog-to-digital converter ADC1 and the storage of the data in the memory MEM. The acquisition processing element ACP may for example comprise a processing element with a digital interface to the analog-to-digital converter ADC1 and a digital interface to the memory MEM. The processing element may for example comprise a microcontroller, a DSP, a CPLD or an FPGA with respective interfaces. In a microcontroller or DSP, the functionality of the acquisition processing element ACP may be implemented as computer readable instructions that are executed by a CPU. In a CPLD or FPGA the functionality of the acquisition processing element ACP may be configured in to the CPLD or FPGA.

The processing section PS further comprises a communication processor CP and a communication interface COM.

The communication processor CP may be a device that manages data transfer to and from the oscilloscope OSC. The communication interface COM for any adequate communication standard like for example, Ethernet, WIFI, Bluetooth, NFC, an infrared communication standard, and a visible-light communication standard.

The communication processor CP is coupled to the memory MEM and may use the memory MEM to store and retrieve data.

Of course, the communication processor CP may also be coupled to any other element of the oscilloscope OSC to retrieve device data or to provide device data that is received from the management server.

The post processing element PPE may be controlled by the acquisition processing element ACP and may access the memory MEM to retrieve data that is to be displayed on the display DISP. The post processing element PPE may condition the data stored in the memory MEM such that the display DISP may show the data e.g., as waveform to a user.

The display DISP controls all aspects of signal representation to a user, although not explicitly shown, may comprise any component that is required to receive data to be displayed and control a display device to display the data as required.

It is understood, that even if it is not shown, the oscilloscope OSC may also comprise a user interface for a user to interact with the oscilloscope OSC. Such a user interface may comprise dedicated input elements like for example knobs and switches. At least in part the user interface may also be provided as a touch sensitive display device.

It is understood, that all elements of the oscilloscope OSC that perform digital data processing may be provided as dedicated elements. As alternative, at least some of the above-described functions may be implemented in a single hardware element, like for example a microcontroller, DSP, CPLD or FPGA. Generally, the above-describe logical functions may be implemented in any adequate hardware element of the oscilloscope OSC and not necessarily need to be partitioned into the different sections explained above.

The scheduler according to the present disclosure may be provided as a dedicated element or may be provided in any of the processing elements that are already present in the oscilloscope OSC, especially in the processing section PS.

It is understood, that although only a single signal path is shown in the vertical system VS, any other number of signal paths is possible.

The scheduler may be coupled to any of the elements of the oscilloscope OSC to power down or up the respective element.

The scheduler may in embodiments, be provided as a "self-contained" element, that does not need any other element of the oscilloscope OSC to operate. This allows turning off all other elements of the oscilloscope OSC, while the scheduler may comprise a clock and a memory for storing the operations time schedules and the operation mode definitions. Such a scheduler may then wake-up any of the other elements as required.

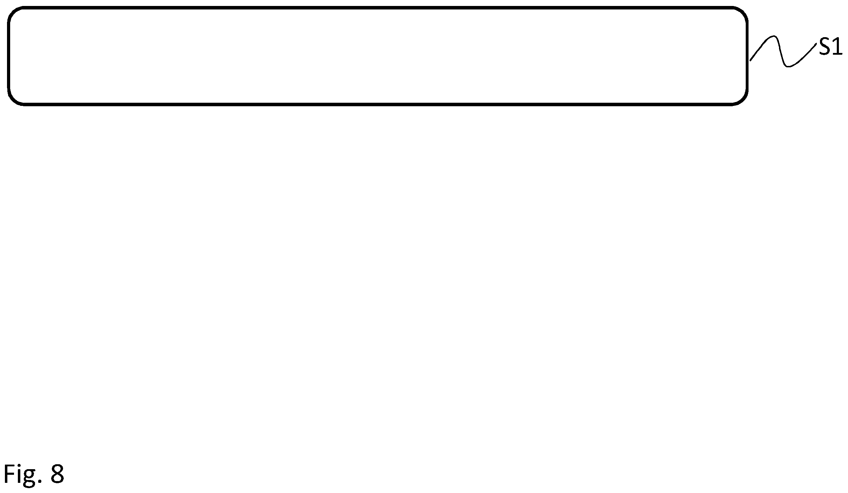

For sake of clarity in the following description of the method-based Fig. 8 the reference signs used above in the description of apparatus based Figs. 1 - 7 will be maintained.

Figure 8 shows a method for controlling a measurement application device 100, 200, 300, 400, 500-1, 500-2, 500-3. The method comprises selectively controlling S1 at least one of the signal measurement paths 101-1 - 101-n, 201-1 - 201-4, 301-1 - 301-n, 401-1 - 401-n of the measurement application device 100, 200, 300, 400, 500-1, 500-2, 500-3 depending on a selected one of a number of operating modes to power down at least one of the signal processing components 102-1 - 102-n, 202-1 - 202-n, 302-1 - 302-n, 402-1 - 402-n, or to power up at least one of the signal processing components 102-1 - 102-n, 202-1 - 202-n, 302-1 - 302-n, 402-1 - 402-n of the respective signal measurement path 101-1 - 101-n, 201-1 - 201-4, 301-1 - 301-n, 401-1 - 401-n.

The method may further comprise controlling the number of signal measurement paths 101-1 - 101-n, 201-1 - 201-4, 301-1 - 301-n, 401-1 - 401-n based on at least one of an operations time schedule 310 and a user input 311, 511.

The operations time schedule 310 may define which signal measurement paths 101-1 - 101-n, 201-1 - 201-4, 301-1 - 301-n, 401-1 - 401-n or signal processing components 102-1 - 102-n, 202-1 - 202-n, 302-1 - 302-n, 402-1 - 402-n may be required at specific points in time, while the user input 311, 511 may directly indicate to activate or deactivate the respective signal measurement paths 101-1 - 101-n, 201-1 - 201-4, 301-1 - 301-n, 401-1 - 401-n or signal processing components 102-1 - 102-n, 202-1 - 202-n, 302-1 - 302-n, 402-1 - 402-n.

The method may further comprise selecting an operating mode based on at least one of the operations time schedule 310 and the user input 311, 511. An operations time schedule 310 may define the required signal measurement paths 101-1 - 101-n, 201-1 - 201-4, 301-1 - 301-n, 401-1 - 401-n or signal processing components 102-1 - 102-n, 202-1 - 202-n, 302-1 - 302-n, 402-1 - 402-n for a plurality of time spans, like all days of a week, month or year.

The method may further comprise controlling the signal measurement paths 101-1 - 101-n, 201-1 - 201-4, 301-1 - 301-n, 401-1 - 401-n to power up all signal processing components 102-1 - 102-n, 202-1 - 202-n, 302-1 - 302-n, 402-1 - 402-n based on an activation command 421 received from a user, or selecting an operation mode indicated by the activation command 421. With the activation command 421 the user may override any setting in the measurement application device 100, 200, 300, 400, 500-1, 500-2, 500-3.

The method may also comprise controlling a central processing unit 213 of the measurement application device 100, 200, 300, 400, 500-1, 500-2, 500-3 and a display 214, DISP, DISP1 of the measurement application device 100, 200, 300, 400, 500-1, 500-2, 500-3 to power down or power up according to the selected operation mode.

The method may further comprise defining at least one of operating modes and operations time schedules 310 based on a usage of the measurement application device 100, 200, 300, 400, 500-1, 500-2, 500-3 with an artificial intelligence-based scheduling module 312 that is pre-trained based on usage statistics 533 of the measurement application device 100, 200, 300, 400, 500-1, 500-2, 500-3.

In order to speed-up the warming of the measurement application device 100, 200, 300, 400, 500-1, 500-2, 500-3, the method may also comprise controllably heating-up at least one of the signal processing components 102-1 - 102-n, 202-1 - 202-n, 302-1 - 302-n, 402-1 - 402-n with at least one heating element 422-1, 422-2, and controlling the heating element 422-1, 422-2 based on the selected one of the operating modes.

In order to inform a user about the current state of the measurement application device 100, 200, 300, 400, 500-1, 500-2, 500-3, the method may comprise outputting the current operating state of the measurement application device 100, 200, 300, 400, 500-1, 500-2, 500-3 with a status interface 423.

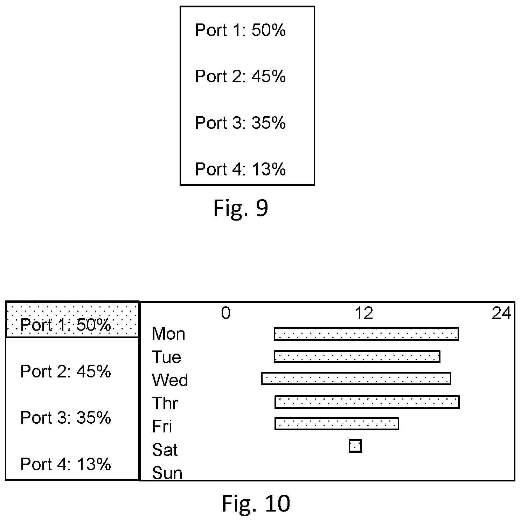

Figure 9 shows a possible user information diagram that may be shown to a user via the display of a measurement application device 100, 200, 300, 400, 500-1, 500-2, 500-3 according to the present disclosure.

The diagram is a list of the ports, in this case four ports, of a measurement application device 100, 200, 300, 400, 500-1, 500-2, 500-3. In addition to the port number for each one of the ports, the diagram comprises a usage percentage for each port.

The usage percentage indicates to a user how much of the total time i.e., of the 24 hours a day or the 7x24 hours of a week or the 365x24 hours a year, the respective port is being used according to current statistical values.

A user may select any one of the ports in the list of figure 9. For that specific port, the enhanced diagram of figure 10 may then be shown.

Figure 10 shows the user information diagram of figure 9, while a day-based usage indication is provided right to the port list.

The day-based usage indication comprises one row or line for each day of the week, while the operating times of the measurement application device 100, 200, 300, 400, 500-1, 500-2, 500-3 are shown as horizontal bars in the diagram.

For selected port 1 it may be seen, that this port is mainly used from Monday to Friday, while on Fridays the users seem to turn off the measurement application device 100, 200, 300, 400, 500-1, 500-2, 500-3 early. Some usage is also encountered on Saturdays.

The data shown in the diagram of figure 10 allows generating a usage profile as a basis for generating a respective operations time schedule for the measurement application device 100, 200, 300, 400, 500-1, 500-2, 500-3. The operations time schedule will then serve to turn on or off the measurement application device 100, 200, 300, 400, 500-1, 500-2, 500-3 with some foresight.

To generate the usage profile, the data shown in the diagram of figure 10 may be averaged over a certain period of time, for example days, weeks or months.

If an artificial intelligence-based scheduling module 312 is used, the usage data may permanently be provided to the artificial intelligence-based scheduling module 312 for further learning.

In addition, such a usage profile may be stored, for example, on a central controller 531. If multiple measurement application devices 100, 200, 300, 400, 500-1, 500-2, 500-3 are used in the same department or laboratory, new devices may be trained with the usage data stored on the central controller 531. As indicated above, the artificial intelligence-based scheduling modules 312 may also be provided with data from a time schedule of the respective users and a holiday calendar.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the spirit and scope of the disclosure. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, which depend on the specific application and implementation. These attributes can include, but are not limited to cost, strength, durability, life cycle cost, marketability, appearance, packaging, size, serviceability, weight, manufacturability, ease of assembly, etc. As such, to the extent any embodiments are described as less desirable than other embodiments or prior art implementations with respect to one or more characteristics, these embodiments are not outside the scope of the disclosure and can be desirable for particular applications.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted. In other words, the descriptions of processes herein are provided for the purpose of illustrating certain embodiments, and should in no way be construed so as to limit the claims.

Accordingly, it is to be understood that the above description is intended to be illustrative and not restrictive. Many embodiments and applications other than the examples provided would be apparent upon reading the above description. The scope should be determined, not with reference to the above description, but should instead be determined with reference to the appended claims, along with the full scope of equivalents to which such claims are entitled. It is anticipated and intended that future developments will occur in the technologies discussed herein, and that the disclosed systems and methods will be incorporated into such future embodiments. In sum, it should be understood that the application is capable of modification and variation.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the spirit and scope of the invention. Additionally, the features of various implementing embodiments may be combined to form further embodiments of the invention.

### LIST OF REFERENCE SIGNS

- 100, 200, 300, 400, 500-1, 500-2, 500-3: measurement application device
- 101-1 - 101-n, 201-1 - 201-4: signal measurement path
- 301-1 - 301-n, 401-1 - 401-n: signal measurement path
- 102-1 - 102-n, 202-1 - 202-n: signal processing component
- 302-1 - 302-n, 402-1 - 402-n: signal processing component
- 103, 203, 303, 403: measurement signal
- 104, 204, 304, 404: scheduler

- 210-1 - 210-4: port
- 211: signal processor
- 213: central processing unit
- 214: display

- 310: operations time schedule
- 311, 511: user input
- 312: artificial intelligence-based scheduling module

- 420: communication interface
- 421: activation command
- 422-1, 422-2: heating element
- 423: status interface

- 530: measurement application setup
- 531: central controller
- 532: network
- 533: usage statistics

- OSC1: oscilloscope
- HO: housing
- MIP1, MIP2, MIP3, MIP4: measurement input
- SIP: signal processing
- DISP1: display
- SYM: symbol
- BUT: button

- OSC: oscilloscope
- VS: vertical system
- SC: signal conditioning
- ATT: attenuator
- AMP1: amplifier
- FI1: filter
- ADC1: analog-to-digital converter

- TS: triggering section
- AMP2: amplifier
- FI2: filter
- TS1: trigger system

- HS: horizontal system

- PS: processing section
- ACP: acquisition processing element
- MEM: memory
- PPE: post processing element

- DISP: display

- S1: method step

## Claims

1. Measurement application device (100, 200, 300, 400, 500-1, 500-2, 500-3), comprising:
a number of signal measurement paths (101-1 - 101-n, 201-1 - 201-4, 301-1 - 301-n, 401-1 - 401-n), each one of the number of signal measurement paths (101-1 - 101-n, 201-1 - 201-4, 301-1 - 301-n, 401-1 - 401-n) comprising a plurality of signal processing components (102-1 - 102-n, 202-1 - 202-n, 302-1 - 302-n, 402-1 - 402-n); and
a scheduler (104, 204, 304, 404) coupled to the number of signal measurement paths (101-1 - 101-n, 201-1 - 201-4, 301-1 - 301 -n, 401-1 - 401-n);
wherein the scheduler (104, 204, 304, 404) is configured to selectively control at least one of the signal measurement paths (101-1 - 101-n, 201-1 - 201-4, 301-1 - 301-n, 401-1 - 401-n) depending on a selected one of a number of operating modes to power down at least one of the signal processing components (102-1 - 102-n, 202-1 - 202-n, 302-1 - 302-n, 402-1 - 402-n), or to power up at least one of the signal processing components (102-1 - 102-n, 202-1 - 202-n, 302-1 - 302-n, 402-1 - 402-n).

2. Measurement application device (100, 200, 300, 400, 500-1, 500-2, 500-3) according to claim 1, wherein the scheduler (104, 204, 304, 404) is configured to control the number of signal measurement paths (101-1 - 101-n, 201-1 - 201-4, 301-1 - 301-n, 401-1 - 401-n) based on at least one of an operations time schedule (310) and a user input (311, 511).

3. Measurement application device (100, 200, 300, 400, 500-1, 500-2, 500-3) according to any one of the preceding claims, wherein each one of the operating modes defines which signal processing components (102-1 - 102-n, 202-1 - 202-n, 302-1 - 302-n, 402-1 - 402-n) of which ones of the signal measurement paths (101-1 - 101-n, 201-1 - 201-4, 301-1 - 301-n, 401-1 - 401-n) are to be powered down.

4. Measurement application device (100, 200, 300, 400, 500-1, 500-2, 500-3) according to claim 3, wherein at least one of the operating modes specifies that at least one of:
at least one of the signal measurement paths (101-1 - 101-n, 201-1 - 201-4, 301-1 - 301-n, 401-1 - 401-n) is to be completely powered down, while at least one of the signal processing components (102-1 - 102-n, 202-1 - 202-n, 302-1 - 302-n, 402-1 - 402-n) of at least one of the remaining signal measurement paths (101-1 - 101-n, 201-1 - 201-4, 301-1 - 301-n, 401-1 - 401-n) is to be powered up;
at least one of the signal measurement paths (101-1 - 101-n, 201-1 - 201-4, 301-1 - 301-n, 401-1 - 401-n) is to be completely powered down, while at least one of the remaining signal measurement paths (101-1 - 101-n, 201-1 - 201-4, 301-1 - 301-n, 401-1 - 401-n) is to be completely powered up; and
all of the signal measurement paths (101-1 - 101-n, 201-1 - 201-4, 301-1 - 301-n, 401-1 - 401-n) are to be completely powered down.

5. Measurement application device (100, 200, 300, 400, 500-1, 500-2, 500-3) according to claim 2 and any one of claims 3 and 4, wherein the scheduler (104, 204, 304, 404) is configured to select an operating mode based on at least one of the operations time schedule (310) and the user input (311, 511).

6. Measurement application device (100, 200, 300, 400, 500-1, 500-2, 500-3) according to any one of the preceding claims 2 - 5, comprising an artificial intelligence-based scheduling module (312) that is pre-trained based on usage statistics (533) of the measurement application device (100, 200, 300, 400, 500-1, 500-2, 500-3) to define operating modes and operations time schedules (310) based on the usage of the measurement application device (100, 200, 300, 400, 500-1, 500-2, 500-3).

7. Measurement application device (100, 200, 300, 400, 500-1, 500-2, 500-3) according to any one of the preceding claims, comprising a communication interface (420) that is coupled to the scheduler (104, 204, 304, 404) and that is configured to receive an activation command (421), wherein the scheduler (104, 204, 304, 404) is configured to control the signal measurement paths (101-1 - 101-n, 201-1 - 201-4, 301-1 - 301-n, 401-1 - 401-n) to power up all signal processing components (102-1 - 102-n, 202-1 - 202-n, 302-1 - 302-n, 402-1 - 402-n) based on the activation command (421), or to select an operation mode indicated by the activation command (421).

8. Measurement application device (100, 200, 300, 400, 500-1, 500-2, 500-3) according to any one of the preceding claims, comprising at least one heating element (422-1, 422-2) that is configured to controllably heat-up at least one of the signal processing components (102-1 - 102-n, 202-1 - 202-n, 302-1 - 302-n, 402-1 - 402-n);
wherein the scheduler (104, 204, 304, 404) is configured to control the heating element (422-1, 422-2) based on the selected one of the operating modes.

9. Measurement application device (100, 200, 300, 400, 500-1, 500-2, 500-3) according to any one of the preceding claims, comprising a status interface (423) that is configured to output the current operating state of the measurement application device (100, 200, 300, 400, 500-1, 500-2, 500-3).

10. Measurement application device (100, 200, 300, 400, 500-1, 500-2, 500-3) according to any one of the preceding claims, comprising a central processing unit (213) that is coupled to the signal measurement paths (101-1 - 101-n, 201-1 - 201-4, 301-1 - 301-n, 401-1 - 401-n) and a display (214, DISP, DISP1) that is coupled to the central processing unit (213);
wherein the scheduler (104, 204, 304, 404) is further configured to control the central processing unit (213) and the display (214, DISP, DISP1) to power down or power up according to the selected operation mode.

11. Measurement application setup (530), comprising:
a central controller (531); and
a plurality of measurement application devices (100, 200, 300, 400, 500-1, 500-2, 500-3) according to any one of the preceding claims that are communicatively coupled to the central controller (531);
wherein the central controller (531) is configured to retrieve usage statistics (533) from the measurement application devices (100, 200, 300, 400, 500-1, 500-2, 500-3); and
wherein the central controller (531) is configured to receive a user input (311, 511) and to transmit the user input (311, 511) to at least one of the measurement application devices (100, 200, 300, 400, 500-1, 500-2, 500-3), the user input (311, 511) indicating at least one of an operation mode and an operations time schedule (310).

12. Method for controlling a measurement application device (100, 200, 300, 400, 500-1, 500-2, 500-3) according to any one of the preceding claims 1 - 10, the method comprising:
selectively controlling (S1) at least one of the signal measurement paths (101-1 - 101-n, 201-1 - 201-4, 301-1 - 301-n, 401-1 - 401-n) depending on a selected one of a number of operating modes to power down at least one of the signal processing components (102-1 - 102-n, 202-1 - 202-n, 302-1 - 302-n, 402-1 - 402-n), or to power up at least one of the signal processing components (102-1 - 102-n, 202-1 - 202-n, 302-1 - 302-n, 402-1 - 402-n) of the respective signal measurement path (101-1 - 101-n, 201-1 - 201-4, 301-1 - 301-n, 401-1 - 401-n).

13. Method according to claim 12, further comprising at least one of:
controlling the number of signal measurement paths (101-1 - 101-n, 201-1 - 201-4, 301-1 - 301-n, 401-1 - 401-n) based on at least one of an operations time schedule (310) and a user input (311, 511);
selecting an operating mode based on at least one of the operations time schedule (310) and the user input (311, 511);
controlling the signal measurement paths (101-1 - 101-n, 201-1 - 201-4, 301-1 - 301-n, 401-1 - 401-n) to power up all signal processing components (102-1 - 102-n, 202-1 - 202-n, 302-1 - 302-n, 402-1 - 402-n) based on an activation command (421) received from a user, or selecting an operation mode indicated by the activation command (421); and
controlling a central processing unit (213) of the measurement application device (100, 200, 300, 400, 500-1, 500-2, 500-3) and a display (214, DISP, DISP1) of the measurement application device (100, 200, 300, 400, 500-1, 500-2, 500-3) to power down or power up according to the selected operation mode.

14. Method according to any one of claims 12 and 13, further comprising:
defining at least one of operating modes and operations time schedules (310) based on a usage of the measurement application device (100, 200, 300, 400, 500-1, 500-2, 500-3) with an artificial intelligence-based scheduling module (312) that is pre-trained based on usage statistics (533) of the measurement application device (100, 200, 300, 400, 500-1, 500-2, 500-3).

15. Method according to any one of claims 12 to 14, further comprising at least one of:
controllably heating-up at least one of the signal processing components (102-1 - 102-n, 202-1 - 202-n, 302-1 - 302-n, 402-1 - 402-n) with at least one heating element (422-1, 422-2), and controlling the heating element (422-1, 422-2) based on the selected one of the operating modes; and
outputting the current operating state of the measurement application device (100, 200, 300, 400, 500-1, 500-2, 500-3) with a status interface (423).
